# EUROPÄISCHE PATENTANMELDUNG

(11) **EP 2 487 479 A2**
(43) Veröffentlichungstag der Anmeldung: **15.08.2012**
(21) Anmeldenummer: 12152134.8
(22) Anmeldetag: 23.01.2012
(51) Int. Cl.: G01N 1/32, H01J 37/30

(54) **Vorrichtung und Verfahren zur Probenpräparation**

(30) Priorität: 09.02.2011 AT 1682011
(71) Anmelder: Leica Mikrosysteme GmbH, 1170 Wien (AT)
(72) Erfinder: Pfeifer, Thomas, 09405 Zschopau (DE); Plank, Heinz, 2351 Wr. Neudorf (AT)
(74) Vertreter: Patentanwaltskanzlei Matschnig & Forsthuber OG

(57) **Zusammenfassung**

Die Erfindung betrifft einen Probentisch (100) zur Bearbeitung einer Probe (104) in einer Ionenstrahlätzvorrichtung, mit zumindest einer Positionierungsanordnung (101,102,103), welche eine Aufnahmevorrichtung (106) und eine Maske (105) aufweist, wobei in der Aufnahmevorrichtung (106) eine Probe (104) in Bezug auf einen Ionenstrahl, der während eines Ionenstrahlätzvorganges in Richtung des Probentischs (100) gerichtet ist, montierbar ist, und wobei die Probe (104) hinsichtlich ihrer Position relativ zur Maske (105) positionierbar ist, wobei der Probentisch (100) als Wechseltisch ausgeführt ist und zumindest zwei Positionierungsanordnungen (101,102,103) und einen Mechanismus (107) aufweist, der einen Wechsel zwischen Positionierungen ermöglicht, in denen jeweils eine der Positionierungsanordnungen (101,102,103) auf dem Probentisch (100) zu dem Ionenstrahl der Ionenstrahlätzvorrichtung ausrichtbar ist, wobei die Probe (104) in der Positionierungsanordnung (101,102,103) dem Ionenstrahl exponiert ist, wogegen die jeweils übrigen Positionierungsanordnungen (101,102,103) dem Ionenstrahl abgewandt sind, und wobei die Positionierungsanordnungen (101,102,103) in einem gemeinsamen Rezipienten angeordnet sind. Die Erfindung betrifft weiters ein Verfahren zum sequentiellen Präparieren von zumindest zwei Proben in einer Ionenstrahlätzanlage unter Verwendung des erfindungsgemäßen Probentisches.

## Beschreibung

Die Erfindung betrifft einen Probentisch zur Bearbeitung einer Probe in einer Ionenstrahlätzvorrichtung, mit zumindest einer Positionierungsanordnung, welche eine Aufnahmevorrichtung und eine Maske aufweist, wobei in der Aufnahmevorrichtung eine Probe in Bezug auf einen Ionenstrahl, der während eines Ionenstrahlätzvorganges in Richtung des Probentischs gerichtet ist, montierbar ist, und wobei die Probe hinsichtlich ihrer Position relativ zur Maske positionierbar ist.

Die Erfindung betrifft weiters ein Verfahren zur Probenpräparation in einer Ionenstrahlätzanlage.

Das Ionenstrahlätzen ist ein häufig angewendetes Verfahren zum Präparieren von Proben, deren Struktur typischerweise anschließend in der Rasterelektronenmikroskopie (REM) und der Transmissionselektronenmikroskopie (TEM) untersucht wird. Diese Technik findet insbesondere in der Forschung, der Materialforschung sowie der Qualitätskontrolle vieler Werkstoffe wie Halbleiter, Metalle, Keramiken, Kunststoffe und dergleichen Anwendung. Zum Durchführen des Verfahrens werden die Proben auf einem Probentisch einer Ionenstrahlätzanlage montiert und im Strahlengang eines oder mehrerer Ionenstrahlen justiert. Ionenstrahlätzanlagen sind typischerweise Hochvakuumanlagen, die mit einem Basisdruck von 10⁻⁶ mbar arbeiten. Als Ionen werden meistens Argon-Ionen üblicherweise bei einer Beschleunigungsspannung von 1 bis 10 kV verwendet. Die Qualität der Bildauflösung im Elektronenmikroskop ist hierbei ganz wesentlich von der Güte der präparierten Probe abhängig. Unter den bekannten Ionenstrahlätzverfahren finden sich in Praxis insbesondere das lonenstrahlböschungsätzen, das lonenpolieren von REM-Proben, das Drahtabschattungsverfahren und die Ionenstrahlpräparation von TEM-Standard-Proben. Während die letzten beiden Verfahren für TEM-Proben verwendet werden, wird das Ionenstrahl-Böschungsätzen zum Herstellen von REM-Querschnittsproben genutzt. Beim Böschungsätzen werden Profile der Probe mit dem Ionenstrahl freigelegt, wobei ein Bereich der Probe durch eine auf der Oberfläche der Probe angeordnete oder zur Oberfläche der Probe justierte Maske vor der Materialabtragung durch den Ionenstrahl geschützt ist. Als besonders effektiv in der Herstellung hochqualitativer REM-Proben hat sich ein Ionenstrahl-Böschungsätzverfahren erwiesen, bei welchem zumindest zwei Ionenstrahlen, vorzugsweise drei Ionenstrahlen, unter einem vorgegebenen Winkel zueinander auf die Probenoberfläche geführt werden. Dieses Verfahren ist in der WO 2008/106815 A2 offenbart.

Die aus dem Stand der Technik bekannten bzw. derzeit auf dem Markt befindlichen Ionenstrahlätzanlagen haben den Nachteil, dass nach jedem Ätzvorgang ein manueller Probenwechsel notwendig ist. In den meisten Fällen erfordert ein Probenwechsel ein Belüften und Öffnen der Vakuumkammer sowie ein neuerliches Anlegen des Vakuums. Bei Ionenstrahlätzanlagen, die mit einer Schleuse arbeiten, ist bei jedem Probenwechsel ein Ein- und Ausschleusen notwendig. Diese Schleusvorgänge machen ebenfalls ein Be- und Entlüften von Anlagenbereichen erforderlich. Derartige Probenwechsel sind zeitaufwändig und führen zu einer geringeren Geräteauslastung, geringerem Probendurchlauf und folglich einer geringeren Wirtschaftlichkeit. Weiters ist es nicht möglich, derartige Vorrichtungen über längere Zeit durchgehend auszulasten (z.B. über Nacht), ohne dass ein manueller Probenwechsel durch einen Bediener erforderlich ist. Darüber hinaus stellt jeder Probenwechsel aufgrund des Belüftens eine Kontaminationsmöglichkeit mit Luftpartikeln dar, wodurch ein Geräteservice in kürzeren Zeitabständen notwendig ist.

In DE-OS 2313 096 ist eine Probenhalterung für das Ätzen von dünnen Schichten beschrieben, bei der mehrere Proben auf einem Drehteller wahlweise in einen Ionenstrahl positioniert werden.

Es ist eine Aufgabe der Erfindung, die aus dem Stand der Technik bekannten Nachteile zu beseitigen. Insbesondere soll mit der Erfindung eine bessere Geräteauslastung und damit höhere Wirtschaftlichkeit erreicht sowie die Anzahl der Probenwechsel möglichst klein gehalten werden.

Diese Aufgabe wird erfindungsgemäß dadurch gelöst, dass bei dem Probentisch, der als Wechseltisch ausgeführt ist und zumindest zwei Positionierungsanordnungen und einen Mechanismus aufweist, der einen Wechsel zwischen Positionierungen ermöglicht, in denen jeweils eine der Positionierungsanordnungen auf dem Probentisch zu dem Ionenstrahl der Ionenstrahlätzvorrichtung ausrichtbar ist, wobei die Probe in der Positionierungsanordnung dem Ionenstrahl exponiert ist, wogegen die jeweils übrigen Positionierungsanordnungen dem Ionenstrahl abgewandt sind, die Positionierungsanordnungen in einem gemeinsamen Rezipienten angeordnet sind, und zumindest zwischen der jeweils einen Positionierungsanordnung, die zu dem Ionenstrahl der Ionenstrahlätzvorrichtung ausgerichtet ist, und den jeweils übrigen Positionierungsanordnungen, die dem Ionenstrahl abgewandt sind, zumindest eine Schutzabtrennung angeordnet ist.

Dank der erfindungsgemäßen Anordnung in einem gemeinsamen Rezipienten ist kein Belüften und Öffnen von Anlagenbereichen, z.B. der Vakuumkammer, nach jeder erfolgten Probenpräparation mehr notwendig. Dies kann erst dann durchgeführt werden, nachdem alle Proben mittels Ionenstrahlätzen fertig präpariert wurden. Da die Positionierungsanordnungen in einem gemeinsamen Rezipienten angeordnet sind, können die darauf montierten Proben nacheinander präpariert werden, ohne das Vakuum brechen zu müssen. Auch die Nichtnutzungszeiten verringern sich signifikant, da eine Auslastung der Ionenstrahlätzanlage über einen längeren Zeitraum (z.B. über Nacht) möglich ist, ohne dass ein manuelles Eingreifen zum Probenwechsel durch einen Bediener erforderlich ist.

Der Probentisch wird vorzugsweise in einem Flanschgehäuse montiert, welches vakuumdicht an die Vakuumkammer einer Ionenstrahlätzanlage angeschlossen werden kann. Durch Wechsel der Positionierungen der Positionierungsanordnungen können die Proben vorzugsweise sequentiell dem Ionenstrahl exponiert werden. Während eine Probe dem Ionenstrahl exponiert ist und präpariert wird (Bearbeitungsposition), sind die jeweils übrigen Proben dem Ionenstrahl abgewandt (Warteposition). Nach Beendigung der Präparation wechselt die präparierte Probe von der Bearbeitungsposition in die Warteposition und eine zuvor dem Ionenstrahl abgewandte und noch zu präparierende Probe von der Warteposition in die Bearbeitungsposition.

Die Probenpräparation mittels Ionenstrahlätzen erfolgt vorzugsweise sequentiell. Weiters ist es möglich, nach einer erstem Präparationsvorgang einer jeden Probe in einem ersten Durchgang, einen zweiten oder weiteren Präparationsdurchgang aller oder ausgewählter Proben durchzuführen, ohne dass ein manueller Probenwechsel, der ein Belüften und Öffnen von Anlagenbereichen einschließt, notwendig ist. Beispielsweise besteht bei der Bearbeitung hitzeempfindlicher Proben häufig die Notwendigkeit, während dem Ionenstrahlätzen Pausen einzulegen, um die Probe zu schonen. Dank der Erfindung können hitzeempfindliche Proben daher zum Einlegen der Pause in die Warteposition gewechselt und anschließend in einem zweiten oder weiteren Präparationsdurchgang fertig präpariert werden. Bei bestimmten Anwendungen kann es notwendig sein, hitzeempfindliche Proben, die sich in der Warteposition befinden, zu kühlen. Kühlvorrichtungen für Ionenstrahlätzanlagen sind dem Fachmann bekannt. Bei bestimmten Proben kann es auch notwendig sein, im Anschluss an den Ionenstrahlätzvorgang, der üblicherweise mit einem Ionenstrahl hoher Energie durchgeführt wird, die Probe noch kurz mit einem Ionenstrahl geringerer Energie zu bearbeiten. Durch dieses Bearbeiten mit einem Ionenstrahl geringerer Energie wird ein Reinigungseffekt der zuvor freigelegten Probenoberfläche erzielt. Dank der Erfindung besteht die Möglichkeit, eine größere Anzahl von Proben in beliebiger Reihenfolge mit unterschiedlichen Präparationsparametern zu bearbeiten.

Der Probentisch umfasst zumindest zwei Positionierungsanordnungen, vorzugsweise zumindest drei oder mehr Positionierungsanordnungen. Je mehr Positionierungsanordnungen der Probentisch aufweist, umso höher ist die Auslastung der Anlage. Beispielsweise sind Probentische mit bis zu 10 Positionierungsanordnungen günstig, da hier trotz hoher Auslastung der Ionenstrahlätzanlage der Probentisch eine handliche Dimension aufweist und notwendige Wartungsintervalle, z. B. für die Ionenquelle, eingehalten werden können. Dies schließt jedoch nicht aus, dass der Probentisch auch mehr als 10 Positionierungsanordnungen umfassen kann.

Bei einer bevorzugten Ausführungsform umfasst der Probentisch eine um eine Drehachse drehbare Drehscheibe, wobei die Positionierungsanordnungen vorzugsweise um gleiche Winkel zueinander versetzt auf der drehbaren Drehscheibe angeordnet sind und die Positionierungsanordnungen durch Drehen der Drehscheibe vorzugsweise sequentiell zu dem Ionenstrahl ausrichtbar sind. Durch Drehen der Drehscheibe wechseln die Positionierungsanordnungen mit den darin befestigten Proben somit in die Bearbeitungsposition bzw. in die Warteposition. Diese Ausführungsform ist besonders kompakt und hat darüber hinaus den Vorteil, eine große Anzahl an Positionierungsanordnungen platzsparend auf dem Probentisch unterzubringen. Bei einer ersten Untervariante nach Art eines Horizontal-Drehtisches bzw. Probenkarussels ist die Drehachse der Drehscheibe im Wesentlichen vertikal ausgerichtet. Bei einer zweiten Untervariante nach Art eines Vertikal-Drehtisches ist die Drehachse der Drehscheibe im Wesentlichen horizontal ausgerichtet.

Bei einer anderen vorteilhaften Ausführungsform eines erfindungsgemäßen Probentisches umfasst dieser eine bewegliche, länglich ausgebildete Auflage, wobei die Positionierungsanordnungen der Länge nach, vorzugsweise in regelmäßigen Abständen, auf der länglichen Auflage angeordnet sind und die Positionierungsanordnungen durch Bewegen der Auflage in Längsrichtung sequentiell zu dem Ionenstrahl ausrichtbar sind.

Bei einer bevorzugten Untervariante ist die Auflage als Schiebeschiene ausgebildet, auf welcher die Positionierungsanordnungen befestigt sind.

Um ein genaues und zielgerichtetes Positionieren der jeweiligen Positionierungsanordnung zum Ionenstrahl zu ermöglichen, weist der Probentisch zum Drehen der Drehscheibe bzw. zum Bewegen der Auflage einen steuerbaren Antrieb auf. Das Steuern des Antriebs erfolgt über eine Steuerung auf bekannte Art und Weise. Der Antrieb kann außerhalb oder innerhalb des Vakuums angeordnet sein. Bei einer bevorzugten Variante handelt es sich beim Antrieb um einen steuerbaren Zahnradantrieb, dessen Funktionsweise dem einschlägigen Fachmann gut bekannt ist. Beispielsweise greift zum Drehen der Drehscheibe ein Antriebszahnrad des Antriebs in eine am Außenrand der Drehscheibe befindliche Zahnung ein. Zum längsgerichteten Bewegen der Auflage greift ein Antriebszahnrad des Antriebs beispielsweise in eine sich längs der Auflage entlang erstreckende Zahnung ein. Bei einer weiteren Variante kann der Antrieb direkt an der Antriebsachse der Drehscheibe angreifen. Weiters ist es auch möglich, die Drehscheibe mittels eines vakuumtauglichen Zahnriemens zu bewegen. Vakuumtaugliche Zahnriemen sind aus dem Stand der Technik bekannt.

Während dem Ionenstrahlätzverfahren wird mittels des Ionenstrahls laufend Material von der sich in der Bearbeitungsposition befindlichen Probe abgetragen. Dabei besteht die Gefahr, dass sich diese Materialpartikel auf den in der Warteposition befindlichen Proben niederschlagen und diese folglich verschmutzen, wodurch die Qualität der Proben beeinträchtigt werden kann. Zum Schutz der dem Ionenstrahl abgewandten Positionierungsanordnungen vor Verschmutzung ist es daher von großem Vorteil, dass erfindungsgemäß wie oben erwähnt Schutzabtrennungen zwischen Positionierungsanordnungen angeordnet sind. Hinsichtlich der Materialbeschaffenheit der Schutzabtrennung ist es wichtig, dass diese aus einem vakuumtauglichen und leicht zu reinigenden Material gefertigt ist. Derartige vakuumtaugliche Materialien sind dem einschlägigen Fachmann bekannt. Da die Schutzabtrennung während des Ionenstrahlätzvorgangs auch zumindest teilweise dem Ionenstrahl exponiert ist, sollte es ein Material mit einer sehr geringen Ätzrate sein, um die Abnutzung zu minimieren. In der Praxis haben sich Hartmetalle, insbesondere Stahl, als besonders vorteilhaft erwiesen.

Bei einer ersten Variante ist die Schutzabtrennung dauerhaft auf dem Probentisch angeordnet. Vorzugsweise ist sie mit dem Probentisch verschweißt oder durch Anschrauben oder sonstige Befestigungsmechanismen dauerhaft mit dem Probentisch verbunden.

Bei einer weiteren Variante ist die Schutzabtrennung positionierbar angeordnet. Bei einer ersten Untervariante einer positionierbaren Schutzabtrennung umfasst diese eine klapp-, schieb- oder schwenkbare Abdeckung, welche mittels eines Federmechanismus öffen- und schließbar ist. Darunter sind beispielsweise Abdeckungen zu verstehen, die durch Verschieben, Verschwenken oder Klappen der Abdeckung oder durch Zusammenstauchen der Abdeckung nach Art eines Faltenbalgs eine Öffnung freigeben und dadurch ein Wechseln der Positionierungsanordnungen ermöglichen. Der Federmechanismus kann durch Bewegen des Probentisches beispielsweise entweder durch eine sich bewegende Positionierungsanordnung oder mittels eines Hebels ausgelöst werden, wodurch die Abdeckung eine Öffnung freigibt. Sobald die nächste Positionierungsanordnung in die Bearbeitungsposition gewechselt ist, schließt sich die Abdeckung durch Federkraft wieder.

Bei einer zweiten Variante umfasst die positionierbare Schutzabtrennung eine Abdeckung, welche vakuumtaugliche, im Wesentlichen vertikal verlaufende, überlappende Lamellen oder Bänder nach Art eines Lamellenvorhangs aufweist. Die Lamellen sind beweglich. Beim Wechseln der Positionierung der Positionierungsanordnungen können die Positionierungsanordnungen durch die Lamellen der Abdeckung der Schutzabtrennung hindurchtreten.

Bei einer dritten Variante umfasst die positionierbare Schutzabtrennung zumindest eine klapp-, schieb- oder schwenkbare Abdeckung, welcher ein eigener Antrieb zum Öffnen und Schließen zugeordnet ist. Darunter sind wie bei der oben genannten Variante sowohl Abdeckungen zu verstehen, die durch Verschieben, Verschwenken oder Klappen der Abdeckung oder durch Zusammenstauchen der Abdeckung nach Art eines Faltenbalgs eine Öffnung freigeben und dadurch ein Wechseln der Positionierungsanordnungen ermöglichen. Nachteilig an dieser Variante im Vergleich zur oben genannten Variante mit dem Federmechanismus ist, dass hier ein größerer steuerungstechnischer Aufwand besteht, da das Öffnen und Schließen der Abdeckung zeitlich synchronisiert mit dem Wechseln der Positionierungsanordnungen erfolgen muss.

Bei einer einfach umzusetzenden Realisierung ist jede Positionierungsanordnung von den jeweils angrenzenden Positionierungsanordnungen durch eine Schutzabtrennung getrennt. Zweckmäßigerweise kommt hierbei die Variante zum Einsatz, bei welcher die Schutzabtrennung dauerhaft auf dem Probentisch angeordnet ist.

Eine spezielle Ausführungsform des erfindungsgemäßen Probentisches sieht genau drei Positionierungsanordnungen vor, die auf der Drehscheibe in einem Winkel von 120° angeordnet sind, wobei zwischen den drei Positionierungsanordnungen jeweils eine normal zur Drehscheibe angeordnete und sich radial zur Drehachse erstreckende Schutzabtrennung angeordnet ist.

Der erfindungsgemäße Probentisch ist vorzugsweise in einem Flanschgehäuse, das als Vakuumflansch ausgeführt ist, angeordnet. Das Flanschgehäuse mit dem darin angeordneten Probentisch wird hierin als Probentischflansch bezeichnet. Der Probentischflansch wird an der Vakuumkammer der Ionenstrahlätzanlage angeflanscht. Die Erfindung bezieht sich folglich auch auf einen Probentischflansch, der einen erfindungsgemäßen Probentisch wie oben beschrieben umfasst.

Die Erfindung umfasst weiters ein Verfahren zum sequentiellen Präparieren von zumindest zwei Proben in einer Ionenstrahlätzanlage, bei welchem der erfindungsgemäße Probentisch zur Anwendung kommt.

Das erfindungsgemäße Verfahren umfasst dabei die folgenden Schritte:
(a) Befestigen der Proben in den zumindest zwei Positionierungsanordnungen eines erfindungsgemäßen Probentisches, manuelles Justieren der Proben in den jeweiligen Positionierungsanordnungen,
(b) Anordnen des Probentischs im Rezipienten,
(c) Ausrichten einer der Positionierungsanordnungen zu dem Ionenstrahl durch Bewegen des Probentischs, wobei die Probe in der Positionierungsanordnung dem Ionenstrahl exponiert wird, wogegen die jeweils übrigen Positionierungsanordnungen dem Ionenstrahl abgewandt sind, und Bearbeiten der dem Ionenstrahl exponierten Probe mittels Ionenstrahlätzen,
(d) Wechseln der Positionierungen durch Bewegen des Probentischs und Ausrichten der nächsten Positionierungsanordnung zu dem Ionenstrahl und Präparieren der Probe mittels Ionenstrahlätzen,
(e) Wiederholen der Schritte (c) und (d), bis alle Proben mittels Ionenstrahlätzen präpariert wurden, und
(f) gegebenenfalls Wiederholen der Schritte (c) bis (e).

Vorzugsweise erfolgt das Wechseln der Positionierungen in Schritt (d) sequentiell, d.h. die Proben werden in sequentieller Reihenfolge präpariert.

Wie aus den Verfahrensschritten gut erkennbar ist, werden alle Proben vor dem Anordnen des Probentischs im Rezipienten, das heißt, vor dem Verschließen der Vakuumkammer und dem Anlegen des Vakuums, manuell in den jeweiligen Positionierungsanordnungen justiert (Schritt (a)). Die Masken haben vorzugsweise eine feste Position in den Positionierungsanordnungen. Die Proben werden relativ zu den jeweiligen Masken positioniert. Während des Ionenstrahlätzverfahrens wird die jeweilige justierte Proben-Masken-Einheit durch Wechsel der Positionierungen relativ zum Ionenstrahl positioniert und die Probe mit dem Ionenstrahl bearbeitet. Wie oben bereits erwähnt, können alle oder ausgewählte Proben auch mehrfach in zwei oder mehr Durchläufen bearbeitet werden.

Im Folgenden wird die Erfindung samt weiteren Vorzügen anhand von nicht einschränkenden Ausführungsbeispielen erläutert, die in den beigefügten Zeichnungen dargestellt sind. Die Zeichnungen zeigen:
Fig. 1 Eine perspektivische Ansicht einer ersten Ausführungsform eines erfindungsgemäßen drehbaren Probentisches mit einer vertikalen Drehachse und mit insgesamt drei Positionierungsanordnungen,
Fig. 2 eine perspektivische Ansicht eines Probentischflansches mit dem darin angeordneten Probentisch aus der Fig. 1,
Fig. 3 eine Seitenansicht einer geöffneten Ionenstrahlätzanlage mit dem darin montierten Probentischflansch aus der Fig. 2 in einer ersten, um 90° gekippten Justierposition,
Fig. 4 die Ionenstrahlätzanlage aus der Fig. 3, wobei der Probentischflansch in eine zweite Justierposition geschwenkt ist,
Fig. 5 einen Schnitt durch die geschlossene Vakuumkammer der Ionenstrahlätzanlage der Fig. 3 und Fig. 4, wobei der Probentischflansch in Betriebsposition ist,
Fig. 6 eine Draufsicht auf eine zweite Ausführungsform eines erfindungsgemäßen drehbaren Probentisches mit einer vertikalen Drehachse und einer Vielzahl von Positionierungsanordnungen,
Fig. 7 eine Seitenansicht einer dritten Ausführungsform eines erfindungsgemäßen drehbaren Probentisches mit einer horizontalen Drehachse und einer Vielzahl von Positionierungsanordnungen,
Fig. 8 eine Seitenansicht einer vierten Ausführungsform eines erfindungsgemäßen drehbaren Probentisches mit einer horizontalen Drehachse und einer Vielzahl von Positionierungsanordnungen, und
Fig. 9 eine Seitenansicht einer fünften Ausführungsform eines erfindungsgemäßen Probentisches in Form einer Schiebeschiene.

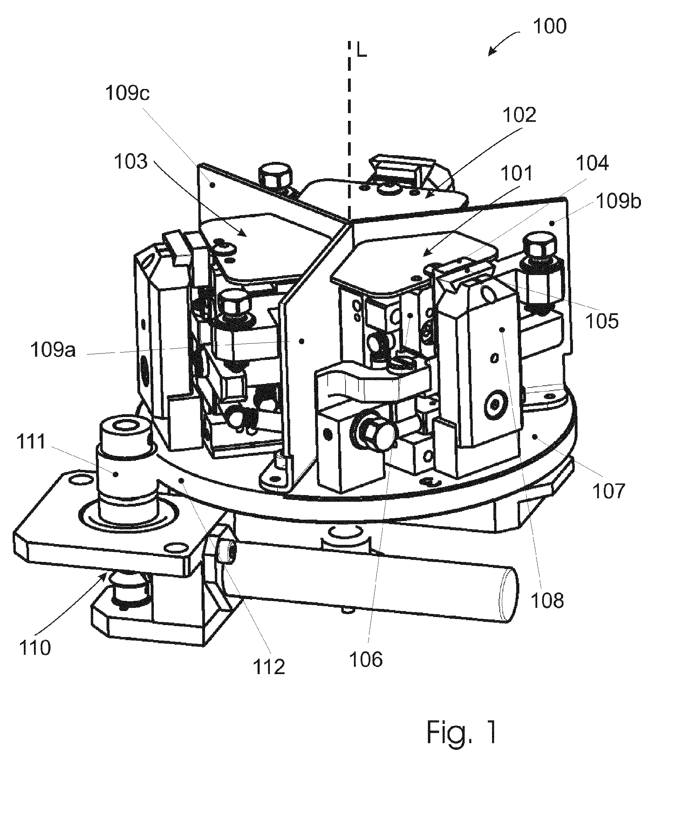

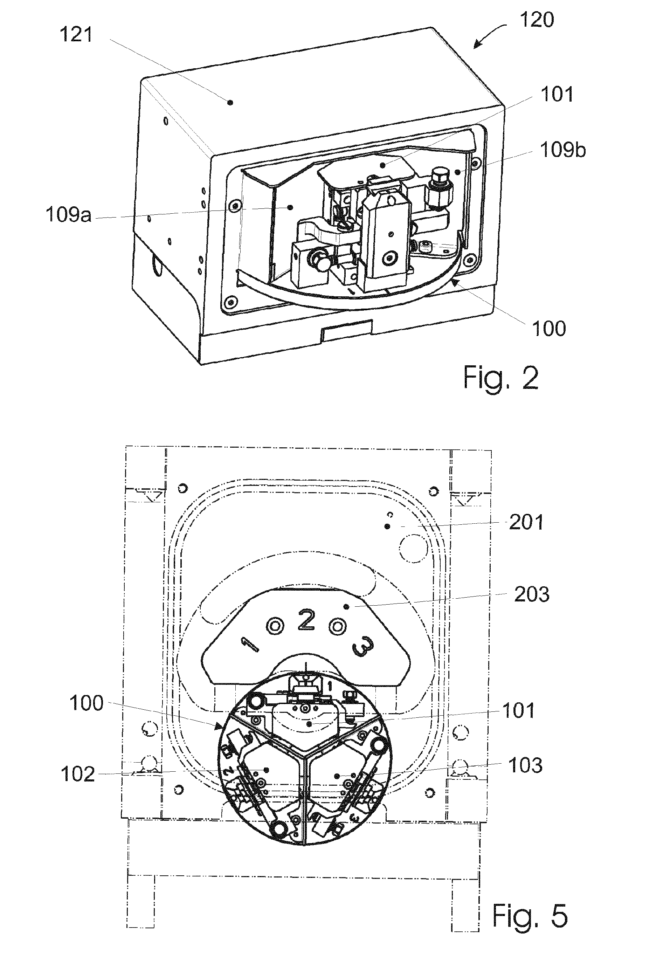

Fig. 1 zeigt eine erste Ausführungsform der Erfindung in Form eines drehbaren Probentisches 100 für eine Ionenstrahlätzanlage, der um eine vertikale Drehachse L drehbar gelagert ist (Horizontal-Drehtisch). Der Probentisch umfasst eine Drehscheibe 107, auf welcher insgesamt drei Positionierungsanordnungen 101,102,103 in einem Winkel von 120° zueinander versetzt angeordnet sind. Der Aufbau der einzelnen Positionierungsanordnungen 101,102,103 ist dem Fachmann an sich bekannt und ist für ein Ionenstrahl-Böschungsätzverfahren, wie es in der WO 2008/106815 A2 beschrieben ist, konzipiert. Jede Positionierungsanordnung 101,102,103 umfasst eine in zwei Ebenen einstellbare Aufnahmevorrichtung 106, auf welcher eine Probe 104 montierbar ist, sowie einen Maskenhalter 108 mit einer Maske 105. Zwischen den drei Positionierungsanordnungen 101,102,103 ist jeweils eine normal zur Drehscheibe 107 angeordnete und sich radial zur Drehachse erstreckende Schutzabtrennung 109a,109b,109c in Form eines metallenen Schutzblechs angeordnet. Wie aus den Fig. 2 und 5 besser ersichtlich ist, haben die Schutzabtrennungen 109a,109b,109c den Zweck, eine Verschmutzung der sich in Warteposition befindlichen Positionierungsanordnungen 101,102,103 durch das während des Ätzvorgangs abgetragene Probenmaterial zu verhindern. Zum Drehen des Probentisches 100 ist diesem ein Zahnradantrieb 110 zugeordnet, wobei ein Antriebszahnrad 111 in eine am Außenrand 112 der Drehscheibe befindliche Zahnung (nicht gezeigt) eingreift.

Fig. 2 zeigt eine perspektivische Ansicht eines Probentischflansches 120 mit dem darin montierten Probentisch 100 aus der Fig. 1. Wie in der Fig. 2 gut ersichtlich ist, ist nur eine der Positionierungsanordnungen 101,102,103 nach außen und folglich dem Ionenstrahl exponiert (Bearbeitungsposition), während die jeweils übrigen Positionierungsanordnungen 101,102,103 im Flanschgehäuse 121 des Probentischflansches 120 angeordnet sind und sich somit in der Warteposition befinden. In der Fig. 2 befindet sich die Positionierungsanordnung 101 in der Bearbeitungsposition, während sich die Positionierungsanordnungen 102,103 innerhalb des Flanschgehäuses 121 in der Warteposition befinden. Durch Drehen des Probentisches 100 um einen Winkel von 120° wechseln die Positionierungsanordnungen 101,102,103 ihre Position, d.h. sie wechseln von der Warteposition in die Bearbeitungsposition bzw. von der Bearbeitungsposition in die Warteposition, wobei der Wechsel vorzugsweise sequentiell erfolgt. Die jeweiligen Positionierungsanordnungen 101,102,103 in der Warteposition sind durch die entsprechenden Schutzabtrennungen 109a,109b,109c vor Verschmutzung durch das beim Ätzvorgang entstehende, abgetragene Probenmaterial geschützt.

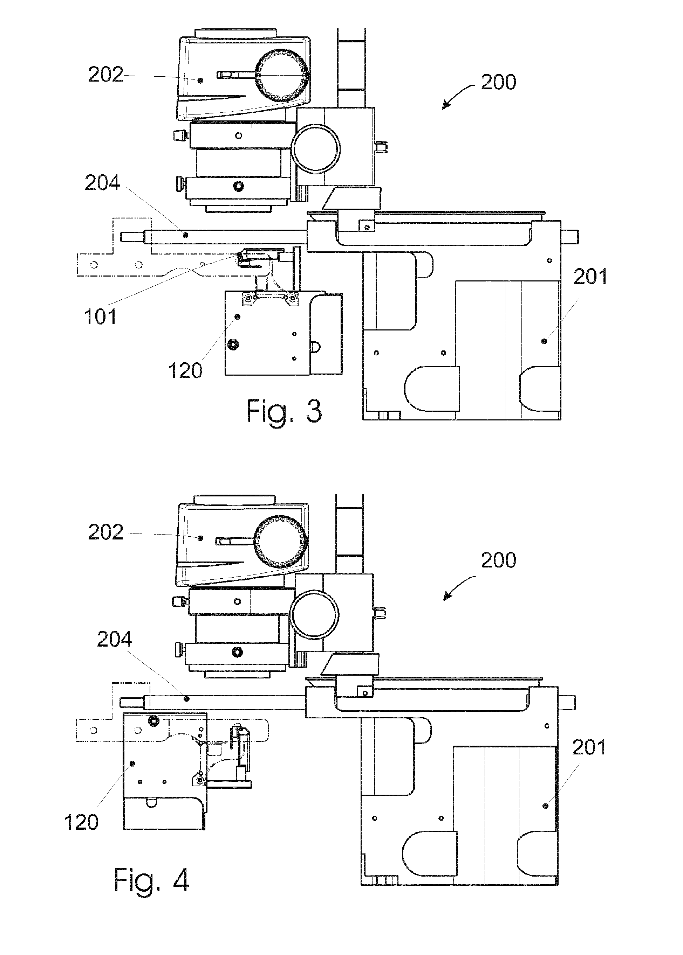

Die Fig. 3 und 4 zeigen jeweils Seitenansichten einer geöffneten Ionenstrahlätzanlage 200 mit dem darin montierten Probentischflansch 120 aus der Fig. 2. Der Probentischflansch 120 wird bei Inbetriebnahme der Ionenstrahlätzanlage 200 vakuumdicht an der Vakuumkammer 201 (Rezipient), in welcher die Ionenquellen angeordnet sind, angeschlossen (siehe Fig. 5, welche einen Schnitt durch eine geschlossene Vakuumkammer 201 mit angeschlossenem Probentischflansch 120 zeigt). Die drei Proben 104 werden vor dem Anlegen des Vakuums und vor Beginn des Ionenstrahlätzvorgangs auf den Positionieranordnungen 101,102,103 des Probentisches 100 montiert und gleich anschließend manuell relativ zu den jeweiligen Masken 105 justiert. Das Justieren erfolgt einerseits durch exaktes Montieren (Aufkleben) der Probe 104 auf der jeweiligen Aufnahmevorrichtung 106 und in Bezug zur fest positionierten Maske 105 mittels Positionierschrauben. Das vorausgehende Justieren der Proben ermöglicht ein vorzugsweise sequentielles Ionenstrahlätzen aller Proben in einem Durchgang oder, falls erforderlich, aller oder ausgewählter Proben in einem zweiten oder weiteren Durchgang. In der Fig. 3 befindet sich der Probentischflansch 120 in einer ersten, um 90° gekippten Justierposition. In der Fig. 4 befindet sich der Probentischflansch 120 in seiner zweiten Justierposition, wobei diese Justierposition auch die Position darstellt, in welcher der Probentischflansch 120 anschließend mittels einer Tragschiene 204 horizontal in Richtung Vakuumkammer 201 verschoben und an diese vakuumdicht angeschlossen wird. Zur Probenjustierung weist die Ionenstrahlätzanlage 200 weiters ein Binokular 202 auf.

Nach dem Beladen und Justieren der drei Proben wird der Probentischflansch 120 an den Rezipienten der Ionenstrahlätzanlage 200 angeschlossen und die Probenkammer zum Herstellen eines Hochvakuums (üblicherweise zumindest 10⁻⁶ mbar) abgepumpt. Die Fig. 5 zeigt eine Draufsicht durch einen Schnitt durch die geschlossene Vakuumkammer 201 mit angeschlossenem Probentischflansch 120, wobei der Probentisch 100 hervorgehoben ist. Die Positionierungsanordnung 101 befindet sich in der Bearbeitungsposition, während sich die übrigen Positionierungsanordnungen 102 und 103 in der Warteposition befinden. Das Ätzverfahren erfolgt gemäß dem oben genannten Ionenstrahl-Böschungsätzverfahren aus der WO 2008/106815 A2. Demgemäß sind wie in der WO 2008/106815 A2 beschrieben drei Ionenstrahlen, die in einer Ionenquelle 203 integriert sind, unter einem vorgegebenen Winkel zueinander auf die Probenoberfläche der Probe 104 der Positionierungsanordnung 101 geführt. Die Proben werden sequentiell präpariert, indem die Positionierungsanordnungen 101,102,103 durch Drehen des Probentischs in die jeweiligen Bearbeitungs- bzw. Wartepositionen gebracht werden.

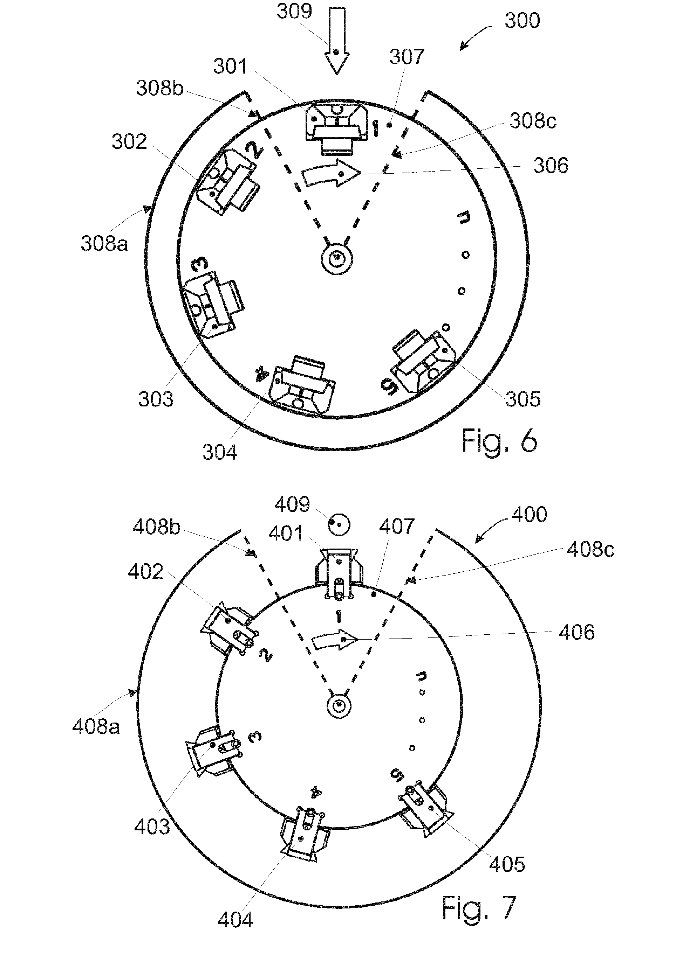

Die Fig. 6 zeigt eine Draufsicht auf eine zweite Ausführungsform eines drehbaren Probentisches 300, der wie der Probentisch 100 ebenfalls als karussellartiger Horizontal-Drehtisch mit vertikaler Drehachse ausgebildet ist, aber eine Vielzahl um gleiche Winkel zueinander versetzte und auf einer Drehscheibe 307 angeordnete Positionierungsanordnungen (301,302,303,304,305 ...n) aufweist. Beispielsweise können auf der Drehscheibe 307 bis zu 10 Positionierungsanordnungen (n ≤ 10) angeordnet werden, da auf diese Weise trotz hoher Auslastung der Ionenstrahlätzanlage der Probentisch 300 eine handliche Dimension aufweist und notwendige Wartungsintervalle, z. B. für die Ionenquelle, eingehalten werden können. Die Positionierungsanordnungen des Probentisches 300 entsprechen in ihrem prinzipiellen Aufbau den oben beschriebenen Positionierungsanordnungen 101,102,103. Die Positionierungsanordnung 301 befindet sich in der Bearbeitungsposition, während sich die übrigen Positionierungsanordnungen in der Warteposition befinden. Zum Drehen des Probentisches 300 ist diesem ebenfalls ein oben beschriebener Zahnradantrieb 110 zugeordnet. Der Pfeil 306 stellt die Drehrichtung des Probentisches 300 beim Wechsel der Positionierungen und der Pfeil 309 die Richtung des Ionenstrahls dar, der auf die in der Positionierungsanordnung 301 montierte Probe gerichtet ist. Die Drehscheibe 307 mit den Positionierungsanordnungen ist in einem Schutzgehäuse 308a angeordnet, wobei die Positionierungsanordnung in der Bearbeitungsposition (hier Positionierungsanordnung 301) sich außerhalb des Schutzgehäuses 308a befindet, dem Ionenstrahl exponiert und weiters durch zwei positionierbare, in einem Winkel zueinander angeordnete Schutzabdeckungen 308b,308c (gestrichelte Linien) von den übrigen Positionierungsanordnungen abgeschirmt ist. Die Schutzabdeckungen 308b,308c können wie oben im Detail beschrieben als klapp-, schwenk- oder schiebbare Abdeckungen, beispielsweise in Form von Klapptüren, die mittels eines Federmechanismus oder mittels eines Antriebs öffen- und schließbar sind, ausgeführt sein.

Die Fig. 7 zeigt eine Seitenansicht einer dritten Ausführungsform eines drehbaren Probentisches 400, der als revolverartiger Vertikal-Drehtisch mit einer horizontalen Drehachse ausgebildet ist. Der Probentisch 400 weist eine Vielzahl um gleiche Winkel zueinander versetzte und auf einer Drehscheibe 407 angeordnete Positionierungsanordnungen (401,402,403,404,405 ...n) auf. Beispielsweise können auf der Drehscheibe 407 bis zu 10 Positionierungsanordnungen (n ≤ 10) angeordnet werden, da auf diese Weise trotz hoher Auslastung der Ionenstrahlätzanlage der Probentisch eine handliche Dimension aufweist und notwendige Wartungsintervalle, z. B. für die Ionenquelle, eingehalten Die Positionierungsanordnungen des Probentisches 400 entsprechen in ihrem prinzipiellen Aufbau den oben beschriebenen Positionierungsanordnungen 101,102,103. Die Positionierungsanordnung 401 befindet sich in der Bearbeitungsposition, während sich die übrigen Positionierungsanordnungen in der Warteposition befinden. Zum Drehen des Probentisches 400 ist diesem ebenfalls ein oben beschriebener Zahnradantrieb 110 zugeordnet. Der Pfeil 406 stellt die Drehrichtung des Probentisches 400 beim Wechsel der Positionierungen dar. Der Ionenstrahl tritt durch die Austrittsöffnung 409 (in Draufsicht dargestellt) aus und ist auf die in der Positionierungsanordnung 401 montierte Probe gerichtet. Die Positionierungsanordnungen sind derart auf der Drehscheibe 407 angeordnet, dass der Ionenstrahl parallel zur horizontalen Drehachse des Drehtischs und normal zur Ebene der Drehscheibe 407 gerichtet ist. Wie oben in der Fig. 6 beschrieben, ist auch bei dieser Ausführungsform die Drehscheibe 407 mit den Positionierungsanordnungen in einem Schutzgehäuse 408a angeordnet, wobei die Positionierungsanordnung in der Bearbeitungsposition (hier Positionierungsanordnung 401) sich außerhalb des Schutzgehäuses 408a befindet, dem Ionenstrahl exponiert und weiters durch zwei positionierbare, in einem Winkel zueinander angeordnete Schutzabdeckungen 408b,408c (gestrichelte Linien) von den übrigen Positionierungsanordnungen abgeschirmt ist. Die Schutzabdeckungen 408b,408c können wie oben im Detail beschrieben als klapp-, schwenk- oder schiebbare Abdeckungen, beispielsweise in Form von Klapptüren, die mittels eines Federmechanismus oder mittels eines Antriebs öffen- und schließbar sind, ausgeführt sein.

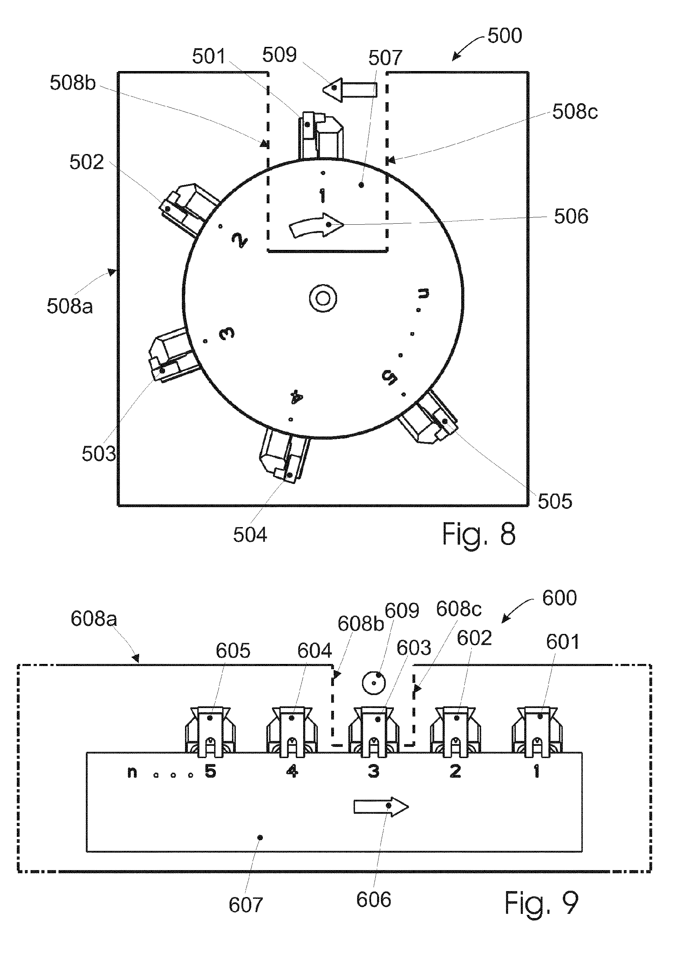

Fig. 8 zeigt eine Seitenansicht einer vierten Ausführungsform eines drehbaren Probentisches 500, der als revolverartiger Vertikal-Drehtisch mit einer horizontalen Drehachse ausgebildet ist. Der prinzipielle Aufbau entspricht jenem des Probentisches 400 (siehe Fig. 7). Der Probentisch 500 unterscheidet sich vom Probentisch 400 darin, dass die Positionierungsanordnungen (501,502,503,504,505...n) derart auf einer Drehscheibe 507 angeordnet sind, dass der Ionenstrahl normal zur horizontalen Drehachse gerichtet ist. Beispielsweise können auf der Drehscheibe 507 bis zu 10 Positionierungsanordnungen (n ≤ 10) angeordnet werden, da auf diese Weise trotz hoher Auslastung der Ionenstrahlätzanlage der Probentisch eine handliche Dimension aufweist und notwendige Wartungsintervalle, z. B. für die Ionenquelle, eingehalten Der Pfeil 506 stellt die Drehrichtung des Probentisches 500 beim Wechsel der Positionierungen und der Pfeil 509 die Richtung des Ionenstrahls dar, der auf die in der Positionierungsanordnung 501 montierte Probe gerichtet ist. Zum Drehen des Probentisches 500 ist diesem ebenfalls ein oben beschriebener Zahnradantrieb 110 zugeordnet. Auch bei dieser Ausführungsform ist die Drehscheibe 507 mit den Positionierungsanordnungen in einem Schutzgehäuse 508a angeordnet, wobei sich die Positionierungsanordnung in der Bearbeitungsposition (hier Positionierungsanordnung 501) außerhalb des Schutzgehäuses 508a befindet, dem Ionenstrahl exponiert und weiters durch zwei positionierbare, im Wesentlichen parallel zueinander angeordnete Schutzabdeckungen 508b,508c (gestrichelte Linien) von den übrigen Positionierungsanordnungen abgeschirmt ist. Die Schutzabdeckungen 508b,508c können wie oben im Detail beschrieben als klapp-, schwenk- oder schiebbare Abdeckungen, beispielsweise in Form von Klapptüren, die mittels eines Federmechanismus oder mittels eine Antriebs öffen- und schließbar sind, ausgeführt sein. Die Schutzabdeckungen 508b,508c können auch als vakuumtaugliche, im Wesentlichen vertikal verlaufende, überlappende Lamellen oder Bänder nach Art eines Lamellenvorhangs ausgebildet sein.

Die Fig. 9 zeigt eine Seitenansicht einer fünften Ausführungsform eines Probentisches 600. Der Probentisch umfasst eine reversibel in Längsrichtung verschiebbare, längliche Schiebeschiene 607. Die Positionierungsanordnungen 601,602,603,604,605...n sind in regelmäßigen Abständen der Länge nach auf der Schiebeschiene 607 befestigt und durch Bewegen der Schiebeschiene 607 in Längsrichtung (Pfeil 606) sequentiell zu dem Ionenstrahl (dargestellt als Draufsicht auf die Autrittsöffnung 609 des Ionenstrahls) ausrichtbar sind. Beispielsweise können auf der Schiebeschiene 607 bis zu 10 Positionierungsanordnungen (n ≤ 10) angeordnet werden, da auf diese Weise trotz hoher Auslastung der Ionenstrahlätzanlage der Probentisch eine handliche Dimension aufweist und notwendige Wartungsintervalle, z. B. für die Ionenquelle, eingehalten. Zum Bewegen der Schiebeschiene 607 in Längsrichtung ist dem Probentisch 600 ein oben beschriebener Zahnradantrieb 110 zugeordnet, wobei ein Antriebszahnrad in eine an der Schiebeschiene befindliche Zahnung eingreift. Bei dieser Ausführungsform ist die Schiebeschiene 607 mit den Positionierungsanordnungen in einem Schutzgehäuse 608a angeordnet. Das Schutzgehäuse 608a ist in Längsrichtung größer dimensioniert als in der Fig. 9 gezeigt (durch Strich-Punkt-Linien angedeutet), um ein Längsverschieben der Schiebeschiene 607 in beide Richtungen zu ermöglichen. Die Positionierungsanordnung in der Bearbeitungsposition (hier Positionierungsanordnung 603) befindet sich außerhalb des Schutzgehäuses 608a, ist dem Ionenstrahl exponiert und weiters durch zwei positionierbare, im Wesentlichen parallel zueinander angeordnete Schutzabdeckungen 608b,608c (gestrichelte Linien) von den übrigen Positionierungsanordnungen abgeschirmt ist. Die Schutzabdeckungen 608b,608c können wie oben im Detail beschrieben als klapp-, schwenk- oder schiebbare Abdeckungen, beispielsweise in Form von Klapptüren, die mittels eines Federmechanismus oder mittels eines Antriebs öffen- und schließbar sind, ausgeführt sein. Die Schutzabdeckungen 608b,608c können auch als vakuumtaugliche, im Wesentlichen vertikal verlaufende, überlappende Lamellen oder Bänder nach Art eines Lamellenvorhangs ausgebildet sein.

## Patentansprüche

1. Probentisch (100, 300, 400, 500, 600) zur Bearbeitung einer Probe (104) in einer Ionenstrahlätzvorrichtung, wobei der Probentisch als Wechseltisch mit zumindest zwei Positionierungsanordnungen (101,102,103, 301,...,305, 401,...,405, 501,...505, 601,...605) ausgeführt ist, welche jeweils eine Aufnahmevorrichtung (106) und eine Maske (105) aufweisen, wobei in der Aufnahmevorrichtung (106) eine Probe (104) in Bezug auf einen Ionenstrahl, der während eines Ionenstrahlätzvorganges in Richtung des Probentischs (100, 300, 400, 500, 600) gerichtet ist, montierbar ist, und wobei die Probe (104) hinsichtlich ihrer Position relativ zur Maske (105) positionierbar ist,
wobei der Probentisch (100, 300, 400, 500, 600) einen Mechanismus (107, 307, 407, 507, 607) aufweist, der einen Wechsel zwischen Positionierungen ermöglicht, in denen jeweils eine der Positionierungsanordnungen (101, 301, 401, 501, 603) auf dem Probentisch (100, 300, 400, 500, 600) zu dem Ionenstrahl der Ionenstrahlätzvorrichtung ausrichtbar ist, wobei die Probe (104) in der Positionierungsanordnung (101, 301, 401, 501, 603) dem Ionenstrahl exponiert ist, wogegen die jeweils übrigen Positionierungsanordnungen (102,103, 302...305, 402...405, 502...505, 601,602,604,605) dem Ionenstrahl abgewandt sind,
**dadurch gekennzeichnet, dass**
die Positionierungsanordnungen (101,102,103, 301,...,305, 401,...,405, 501,...505, 601,...605) in einem gemeinsamen Rezipienten angeordnet sind,
zumindest zwischen der jeweils einen Positionierungsanordnung (101, 301, 401, 501, 603), die zu dem Ionenstrahl der Ionenstrahlätzvorrichtung ausgerichtet ist, und den jeweils übrigen Positionierungsanordnungen (102,103, 302...305, 402...405, 502...505, 601,602,604,605), die dem Ionenstrahl abgewandt sind, zumindest eine Schutzabtrennung (109a,109b,109c, 308b,308c, 408b,408c, 508b,508c, 608b,608c) angeordnet ist.

2. Probentisch nach Anspruch 1, **dadurch gekennzeichnet, dass** der Probentisch (100, 300, 400, 500) eine um eine Drehachse (L) drehbare Drehscheibe (107, 307, 407, 507) umfasst, wobei die Positionierungsanordnungen vorzugsweise um gleiche Winkel zueinander versetzt auf der drehbaren Drehscheibe angeordnet sind und die Positionierungsanordnungen durch Drehen der Drehscheibe vorzugsweise sequentiell zu dem Ionenstrahl ausrichtbar sind.

3. Probentisch nach Anspruch 2, **dadurch gekennzeichnet, dass** die Drehachse der Drehscheibe (107, 307) im Wesentlichen vertikal ausgerichtet ist.

4. Probentisch nach Anspruch 2, **dadurch gekennzeichnet, dass** die Drehachse der Drehscheibe (407, 507) im Wesentlichen horizontal ausgerichtet ist.

5. Probentisch nach Anspruch 1, **dadurch gekennzeichnet, dass** der Probentisch (600) eine bewegliche, länglich ausgebildete Auflage (607) umfasst, wobei die Positionierungsanordnungen (601...605) der Länge nach, vorzugsweise in regelmäßigen Abständen, auf der länglichen Auflage angeordnet sind und die Positionierungsanordnungen durch Bewegen der Auflage in Längsrichtung vorzugsweise sequentiell zu dem Ionenstrahl ausrichtbar sind.

6. Probentisch nach Anspruch 5, **dadurch gekennzeichnet, dass** die Auflage als Schiebeschiene (607) ausgebildet ist.

7. Probentisch nach einem der Ansprüche 2 bis 6, **dadurch gekennzeichnet, dass** der Probentisch zum Drehen der Drehscheibe bzw. zum Bewegen der Auflage einen steuerbaren Antrieb aufweist.

8. Probentisch nach einem der Ansprüche 1 bis 7, **dadurch gekennzeichnet, dass** jede Positionierungsanordnung (101,102,103, 301,...,305, 401,...,405, 501,...505, 601,...605) von den jeweils angrenzenden Positionierungsanordnungen durch eine Schutzabtrennung (109a,109b,109c, 308b,308c, 408b,408c, 508b,508c, 608b,608c) getrennt ist.

9. Probentisch (100) nach einem der Ansprüche 1 bis 8, **dadurch gekennzeichnet, dass** die Schutzabtrennung (109a,109b,109c) dauerhaft angeordnet ist.

10. Probentisch (300, 400, 500, 600) nach einem der Ansprüche 1 bis 8, **dadurch gekennzeichnet, dass** die Schutzabtrennung (308b,308c,408b,408c,508b,508c,608b,608c) positionierbar angeordnet ist.

11. Probentisch (300, 400, 500, 600) nach Anspruch 10, **dadurch gekennzeichnet, dass** die positionierbare Schutzabtrennung (308b,308c,408b,408c,508b,508c,608b,608c) eine Schutzabdeckung umfasst, welche mittels eines Federmechanismus öffen- und schließbar ist.

12. Probentisch (500, 600) nach Anspruch 10, **dadurch gekennzeichnet, dass** die positionierbare Schutzabtrennung (508b,508c,608b,608c) eine Schutzabdeckung umfasst, welche überlappende Lamellen aufweist.

13. Probentisch (300, 400, 500, 600) nach Anspruch 10, **dadurch gekennzeichnet, dass** die positionierbare Schutzabtrennung (308b,308c,408b,408c,508b,508c,608b,608c) eine öffen- und schließbare Schutzabdeckung umfasst, welcher ein Antrieb zum Öffnen und Schließen zugeordnet ist.

14. Probentisch nach einem der Ansprüche 2 bis 4 und 8 bis 13, **dadurch gekennzeichnet, dass** genau drei Positionierungsanordnungen (101,102,103,301,302,303,401,402,403, 501,502,503) auf der Drehscheibe (107,307,407,507) in einem Winkel von 120° angeordnet sind, wobei zwischen den drei Positionierungsanordnungen (101,102,103,301,302,303,401,402,403,501,502,503) jeweils eine normal zur Drehscheibe (107,307,407,507) angeordnete und sich radial zur Drehachse (L) erstreckende Schutzabtrennung (109a,109b,109c) angeordnet ist.

15. Probentischflansch (120) umfassend einen Probentisch nach einem der Ansprüche 1 bis 14.

16. Verfahren zum sequentiellen Präparieren von zumindest zwei Proben in einer Ionenstrahlätzanlage, die Schritte umfassend:
(a) Befestigen der Proben in den zumindest zwei Positionierungsanordnungen eines Probentisches nach einem der Ansprüche 1 bis 14, manuelles Justieren der Proben in den jeweiligen Positionierungsanordnungen,
(b) Anordnen des Probentischs im Rezipienten,
(c) Ausrichten einer der Positionierungsanordnungen zu dem Ionenstrahl durch Bewegen des Probentischs, wobei die Probe in der Positionierungsanordnung dem Ionenstrahl exponiert wird, wogegen die jeweils übrigen Positionierungsanordnungen dem Ionenstrahl abgewandt sind, und Bearbeiten der dem Ionenstrahl exponierten Probe mittels Ionenstrahlätzen,
(d) Wechseln der Positionierungen durch Bewegen des Probentischs und Ausrichten der nächsten Positionierungsanordnung zu dem Ionenstrahl und Präparieren der Probe mittels Ionenstrahlätzen,
(e) Wiederholen der Schritte (c) und (d), bis alle Proben mittels Ionenstrahlätzen präpariert wurden, und
(f) gegebenenfalls Wiederholen der Schritte (c) bis (e).

17. Verfahren nach Anspruch 16, **dadurch gekennzeichnet, dass** das Wechseln der Positionierungen in Schritt (d) sequentiell erfolgt.
